Europäisches Patentamt

European Patent Office

Office européen des brevets

(11) Publication number: **0 102 075**
**B1**

(12) EUROPEAN PATENT SPECIFICATION

(45) Date of publication of patent specification: **21.03.90**

(21) Application number: **83108445.4**

(22) Date of filing: **26.08.83**

(51) Int. Cl.⁵: **H 01 L 23/52, H 01 L 23/48**

(54) Semiconductor device with a multilayer structure.

(30) Priority: **30.08.82 JP 149227/82**

(43) Date of publication of application:
**07.03.84 Bulletin 84/10**

(45) Publication of the grant of the patent:
**21.03.90 Bulletin 90/12**

(84) Designated Contracting States:
**DE FR GB IT NL**

(56) References cited:
**EP-A-0 054 129**
**EP-A-0 078 501**
**US-A-4 259 680**
**US-A-4 338 138**

The file contains technical information
submitted after the application was filed and
not included in this specification

(73) Proprietor: **HITACHI, LTD.**
**6, Kanda Surugadai 4-chome Chiyoda-ku**
**Tokyo (JP)**

(72) Inventor: **Nakamura, Thoru**
**5-4-B606, Hon-cho**
**Houya-shi Tokyo (JP)**
Inventor: **Sugaki, Shojiro**
**2-32-D302, Koyasu-cho**
**Hachioji-shi Tokyo (JP)**
Inventor: **Ogirima, Masahiko**
**2-1-23, Nakai**
**Shinjuku-ku Tokyo (JP)**
Inventor: **Nakazato, Kazuo**
**4-14-6, Nishi-koigakubo**
**Kokubunji-shi Tokyo (JP)**
Inventor: **Miyazaki, Takao**
**881-1, Narahara-cho**
**Hachioji-shi Tokyo (JP)**
Inventor: **Yamamoto, Naoki**
**1-10-20, Shiba**
**Kawaguchi-shi Saitama-ken (JP)**
Inventor: **Nagata, Minoru**
**1558, Josuihoncho**
**Kodaira-shi Tokyo (JP)**

(74) Representative: **Strehl, Peter, Dipl.-Ing. et al**
**Patentanwälte Strehl Schübel-Hopf Groening**
**Maximilianstrasse 54 Postfach 22 14 55**
**D-8000 München 22 (DE)**

Courier Press, Leamington Spa, England.

**Description**

Background of the invention

This invention relates to a semiconductor device, and more particularly to a semiconductor device including a bipolar transistor.

The switching speed and power dissipation of a semiconductor device, which are the basic standards for indicating its performance, are determined by the value of the current in the transistor employed therein, and by the electrostatic capacitance of the elements, including parasitic elements, whose charge and discharge must be made with this current. It is desirable that the value of this capacitance is as small as possible, because the power required to operate the transistor is proportional to the capacitance for a given current. In addition, the capacitance must be reduced in order to increase the switching speed of the transistor, because the RC time constant of the transistor is proportional to the capacitance for a given sheet resistance.

Some of the present inventors have developed a semiconductor device including a bipolar transistor, etc., whose power dissipation is small, which operates at a high speed, and wherein the elements occupy a small area, by isolating the active region, etc., of the semiconductor from the substrate thereof by an insulation film, thereby reducing a parasitic capacitance, and they have already filed a patent application therefor (EP—A—0078501).

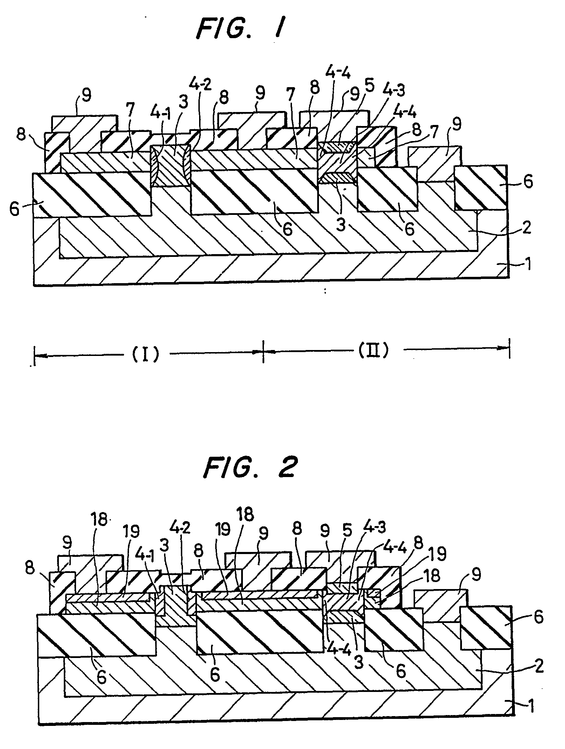

Figure 1 is a section through the structure of one example of this semiconductor device. The following is a description thereof, the material of each part and the conductivity types of the semiconductor layers are prescribed (the first conductivity type is taken to be n-type and the second conductivity type to be p-type) therein so as to simplify the explanation. This also applies to the description of the present invention below, needless to say the materials and conductivity types are not limited thereto.

In Figure 1, numeral 1 denotes an Si substrate of p-type conductivity, 2 a buried layer of $n^+$-type conductivity, and 3, 4 and 5 epitaxially-grown Si layers of which 3 is an n-type conductivity region, 4 a p-type conductivity region, and 5 and $n^+$-type conductivity region. Each of these regions is formed by the doping of impurities. Numeral 6 denotes an insulation film, 7 a polycrystalline semiconductor layer, 8 an insulation film, and 9 an electrode. Numeral (I) denotes a lateral bipolar transistor wherein the electrodes of the emitter and collector regions 4-1 and 4-2 are taken out through the polycrystalline semiconductor layer 7 between the insulation films 6 and 8. Numeral (II) denotes a vertical bipolar transistor wherein the electrodes of base regions (an intrinsic base region 4-3 and a graft base region 4-4) are also taken out through the polycrystalline semiconductor layer 7 between the insulation films 6 and 8.

The structure of the transistors shown in Figure 1 has the advantages that it enables high-speed operation because of their small parasitic capacitance, and that it also enables a reduction of the area of the elements. However, the resistance thereof is not reduced, since the take-out electrodes from the active region formed of a monocrystalline layer are constituted by the polycrystalline semiconductor layer 7. Accordingly, although the time constant, expressed as the product of the resistance and the capacitance, is reduced only by the effect of the reduction of the parasitic capacitance, the realization of high-speed operation is hindered in a circuit wherein a number of multi-emitter structures are used, since the speed of operation is determined by the time constant of the slowest emitter. This is because the time constant of each emitter is affected by the resistance of the polycrystalline semiconductor layer.

Monocrystalline p-type conductivity regions 4 (4-1, 4-2 and 4-4) in contact with the polycrystalline semiconductor layer 7 are formed by the diffusion of the p-type impurities from the polycrystalline semiconductor layer 7. That is, the p-type graft base region 4-4 is formed by diffusion from an unstable polycrystalline semiconductor region with a different diffusion constant, due to differences in the process conditions. This makes it difficult to control the depth of the graft base, and thus it has been difficult to manufacture an element with an emitter ($n^+$-type region 5) of a small area.

US—A—4,338,138 discloses a semiconductor device which is similar in the relevant respects to the structure shown in Figure 1. The first part of claim 1 has been drafted in view of this prior art.

It is an object of the present invention to provide a semiconductor device of the above type which has a higher switching speed.

The invention meets this object by the features characterized in claim 1. The metal silicide region provided on the polycrystalline silicon layer results in a reduction of the resistivity which, in turn, enables a high-speed, low-power operation of the device.

While it is known from EP—A—0 054 129 to combine a metal silicide layer and a polysilicon layer to reduce the sheet resistance, it is important for the present invention that the metal silicide region is separated from the mesa region by a portion of the polycrystalline silicon layer.

Brief description of the drawings

Figure 1 is a section through the structure of one example of a semiconductor device according to the prior art referred to above;

Figure 2 is a section through the structure of a first embodiment of the present invention;

Figures 3A to 3F are sections through the structure of the semiconductor device of Fig. 2, illustrating the sequence of the manufacture of the device; and

Figures 4A to 4D are sections through the structure of a second embodiment of the semiconductor device of the present invention, illustrating the sequence of the manufacture thereof.

## Description of the preferred embodiments

This invention will be described in detail hereunder with reference to the embodiments thereof.

Embodiment 1:

Figure 2 is a section through the structure of a first embodiment of the semiconductor of the present invention. In this figure, the same numbers as those used in Fig. 1 denote the same parts, or equivalent parts, as those in Fig. 1. In a bipolar transistor of the present invention, illustrated by a first embodiment thereof, electrodes 18, 19 takens out from monocrystalline regions (p-type regions $4_{-1}$ to $4_{-4}$) form a double-layer structure to reduce the resistance thereof. The electrodes 18 and 19 have a double-layer structure formed, for instance, of a polycrystalline semiconductor (a polycrystalline silicon layer) as one layer, and a metal silicide as the other. Electrodes 18 and 19 taken out from base regions (4-3 and 4-4) are isolated from an emitter region ($n^+$-type region 5) by an oxide film (insulation film 8), the base and emitter regions can also be formed by a self-alignment method.

The following is a description of a method of manufacturing the semiconductor device of the present invention.

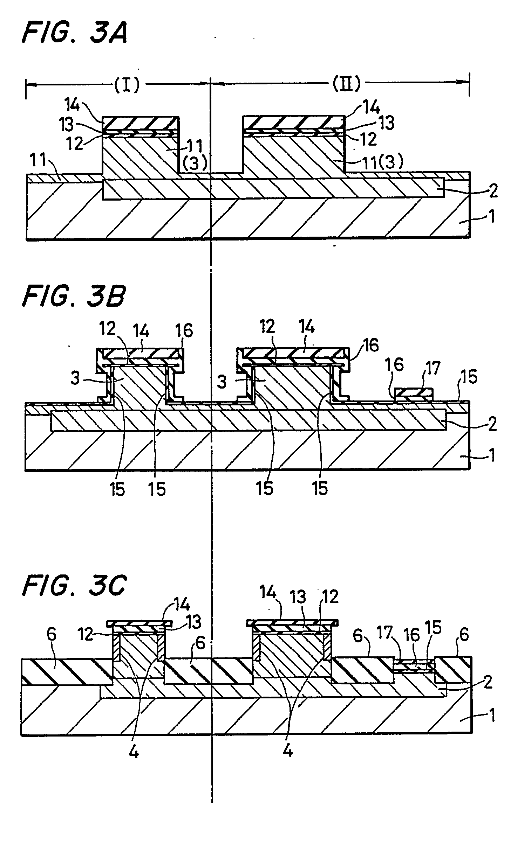

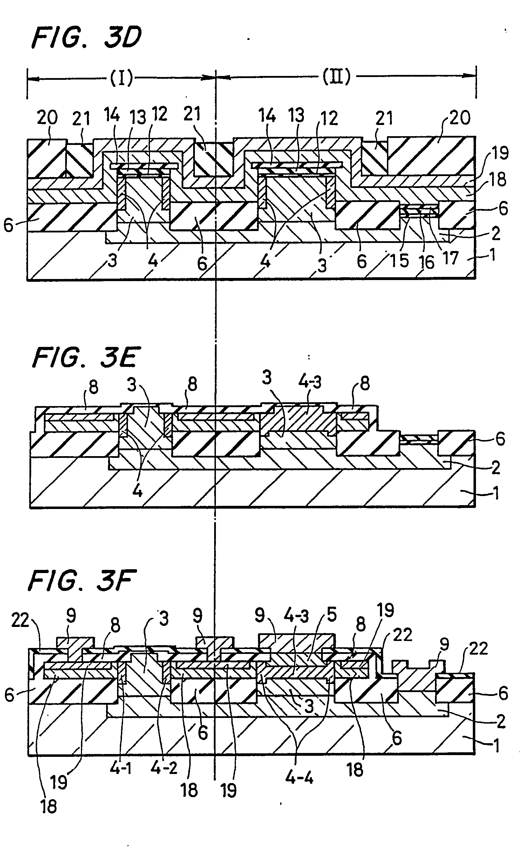

Figures 3A to 3F illustrate the process of manufacturing the semiconductor device shown in Fig. 2. The main process steps thereof will be described hereunder in the order of figure number.

(3A): An $n^+$-type buried layer 2 is formed in a p-type Si substrate 1 by diffusion of impurities, an n-type Si layer 11 is grown epitaxially thereon, a silicon oxide film 12, a silicon nitride film ($Si_3N_4$) 13, and another silicon oxide film 14 are formed over the whole surface in that order, and then these three layers are removed by etching except for the parts that will form the active regions of the transistors. Next, the epitaxial layer 11 is also etched, as shown in the figure, to form mesa regions (3).

(3B): After the mesa regions 3 under the silicon oxide film 12 have been side-etched by wet etching, a silicon oxide film 15 is formed by the thermal oxidation. A silicon nitride film 16 and a silicon oxide film 17 are then deposited in that order, and the oxide film 17 is etched so that it remains only in the region wherein the collector electrode of the longitudinal transistor will be formed. The nitride film 16 is then etched by reactive sputter etching so that it is left only on the sidewalls of the mesa regions 3, and in the region wherein the collector electrode will be formed.

(3C): An oxide film 6 is formed by thermal oxidation, nitride film 16 and the oxide film 15 are removed, and a p-type region 4 is formed by the thermal diffusion of impurities.

(3D): A polycrystalline silicon film 18 and a film 19 of a refractory metal or a metal silicide (e.g a molybdenum silicide, tungsten silicide, palladium silicide, nickel silicide, etc.,) are deposited. When the film 19 is formed of a refractory metal, it is made into the silicide together with the polycrystalline silicon film 18, and is formed into one body therewith, by annealing later. The polycrystalline silicon film 18 is lightly doped to be p-type. Next, a photoresist film (e.g. KTFR of Kodak Company) 20 is applied, and the areas covering the mesa regions are etched so that they are slightly broader than the mesas. A coating of a photoresist (e.g. AZ1350J of Hexit Co., Ltd. or Microposit 1300 of Shipley Co., Ltd.) 21 is then applied so that it penetrates the spaces between the mesa regions (the mesas of the Si epitaxial layer 11) and the photoresist film 20, and also covers their upper surfaces. Therefore these surfaces are flat after the coating. Next, the photoresist is etched in an $O_2$ atmosphere, the etching is stopped when the metal silicide film 19 on the mesa regions is exposed. The layers of the metal silicide film 19 and the polycrystalline silicon film 18 are then removed by a plasma etching method in such a way that only the metal silicide film 19 and the polycrystalline silicon film 18 located on the top surfaces of the mesa regions are removed, so that the silicon oxide film 14 is exposed.

(3E): After the removal of the photoresists, the oxide film 14 is removed, and oxidation is used to form an insulation film 8. Next the nitride film 13 is removed. A base region (p-type region 4-3) is formed thereafter by a method such as ion implantation.

(3F): A passivation silicon nitride film 22 is deposited, a hole is made which will form the emitter region, emitter impurities are added, and thereby the emitter region ($n^+$ region 5) is formed. After that, an electrode 9 for each region is formed.

The semiconductor device of the present invention is formed by the above process. The graft base region 4-4 in the semiconductor device of the present invention can be formed very accurately, since it is not formed by the diffusion of impurities from the polycrystalline silicon film 18. In addition, high-speed operation is enabled, since electrodes taken out from an active region formed by monocrystalline layers have a two-layer structure of a polycrystalline silicon film 18 and a metal silicide film 19 which enables a reduction of the resistance.

Embodiment 2:

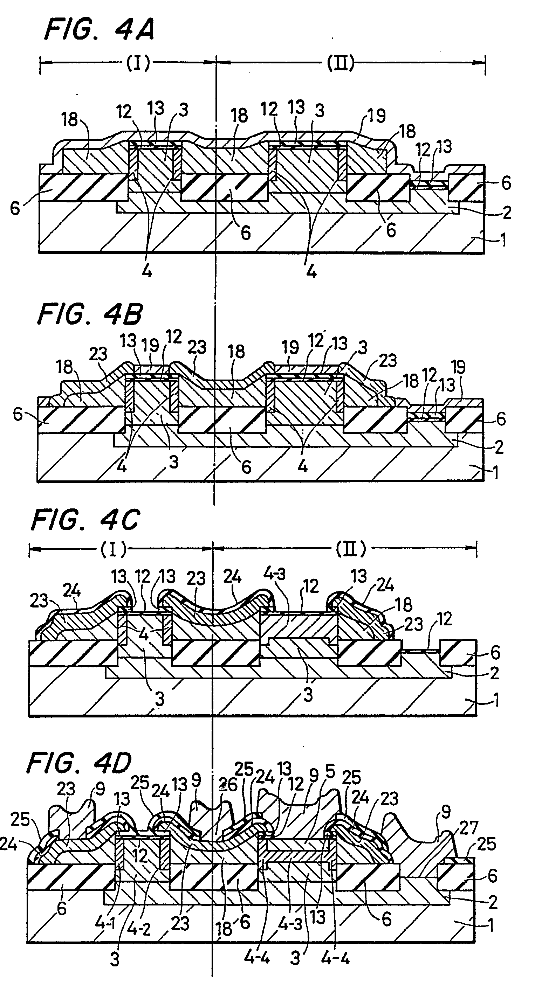

Figures 4A to 4D illustrate the process of manufacturing a second embodiment of the semiconductor device of the present invention. Figure 4D is a section through the structure of a completed semiconductor device of the present invention.

Initially, the same process steps as those for the first embodiment shown in Figs. 3A, 3B and 3C are followed, the process continues from that shown in Fig. 4A. The following is a description of the process steps with reference to Figs. 4A to 4D.

(4A): The polycrystalline silicon film 18 is deposited and doped slightly to be p-type. Next, only the polycrystalline silicon on the mesa regions is removed in the same way as in the first embodiment, and then the polycrystalline silicon film 18 is etched by a conventional photoetching process. After that, the oxide film 14 is etched, and then the film 19 of a refractory metal such as tungsten, molybdenum, palladium, nickel, etc., is deposited.

(4B): The polycrystalline silicon film 18 and the refractory metal film 19 are made to react with each other by annealing, so that a layer 23 of metal silicide is formed only on the polycrystalline silicon film 18 and the regions around it. The annealing temperature depends upon the kind of refractory metal, the deposition method, and the annealing gas. When the refractory metal film 19 is formed of tungsten deposited by a sputtering method and the annealing gas is hydrogen, for instance, an annealing temperature of between 600°C to 900°C is suitable. When the annealing temperature is less than 600°C, the growth rate of the metal silicide is very low, and when it is more than 900°C, the growth rate of the metal silicide layer 23 is extremely high, which results in the formation of the metal silicide layer 23 even in regions some distance from the polycrystalline silicon film 18. This could cause short-circuits, via the metal silicide, between the parts of the pattern of the polycrystalline silicon film 18.

In this annealing process, the annealing conditions are set so that some of the metal silicide layer also grows in the peripheral regions around the polycrystalline silicon film 18. This means that the metal silicide layer 23 is formed around the periphery of the silicon nitride film 13 on the mesa regions (3).

(4C): The refractory metal film 19 is removed by etching (the un-reacted refractory metal film can be left as it is on the metal silicide layer 23), and a silicon oxide film 24 is formed over the metal silicide layer 23 by a oxidation process or a deposition method. The silicon nitride film 13 is then removed by using the oxide film 24 as a mask, and the base region 4-3 is formed by a conventional ion implantation method. During this process step, the collector electrode regions of the lateral transistor region (I) and the longitudinal transistor region (II) are covered with a photoresist to prevent the implantation of ions therein.

(4D): A passivation silicon nitride film 25 is deposited, and a hole is made in the emitter region in the region 4-3. The hole in the emitter region is made so that the part of the oxide film 12 not covered with the nitride film 13 is completely exposed. For this purpose, the etched edges of the nitride film 25 are formed so as to be positioned over the oxide film 24. The emitter region ($n^+$-type region 5) is formed thereafter by ion implantation, and the silicon nitride film 25 and the oxide films 24 and 12 are etched by a conventional photoetching process to form a base contact hole 26 and a collector contact hole 27, and electrodes 9 are then formed.

The process steps described above complete the semiconductor device of the second embodiment of the present invention. In this embodiment, the layers of the polycrystalline silicon film 18 for the base electrodes and the metal silicide film 23 (equivalent to 18 and 19 in Fig. 2) are isolated from the emitter region 5 by the oxide film 24 and the silicon nitride film 13, and thus the base electrodes and the emitter region can be formed so as to be self-aligning. Although the base electrodes are also isolated from the emitter region in a self-aligning manner in the first embodiment, they are isolated from each other in that embodiment by the oxide grown below the silicon nitride film 13. This oxide grown below the silicon nitride film is a called a bird beak. Its growth depends upon the oxidation conditions, the thickness of the silicon oxide film 12, the thickness of the silicon nitride film 13, etc., and it is somewhat inferior to that in the second embodiment in terms of the control of the quantity of growth.

As described above, the present invention enables a reduction in the sheet resistance of the electrodes, which, in turn, enables the high-speed, low-power operation of the element. The following is a concrete example of the effects thereof. In a conventional semiconductor device (shown in Fig. 1), the sheet resistance of the electrodes is about 170 $\Omega/\square$, since polycrystalline silicon is used for base electrodes. On the other hand, the sheet resistance of the electrodes of the device of the present invention, using a metal silicide, is about 10 $\Omega/\square$, that is a reduction of one order of magnitude from that of the conventional device. Accordingly, when a comparison is made between $I^2L$ elements with four collectors, for instance, prepared both by a conventional method and by the method of the present invention, the propagation delay time ($t_{pd\ min}$) of the element of the conventional method is 2500 ps, while that of the element according to the present invention is 500 ps. This large improvement makes it possible to manufacture a PLA (Programmable Logic Array) formed of $I^2Ls$ with at least four collectors, which has been impossible so far.

The effects of the present invention are not changed even when the p-type and n-type conductivities are interchanged in the structure proposed by the present invention.

In addition, when a reverse-operation bipolar transistor is used as the transistor (II) (numeral 5 denotes the collector and 11 the emitter in this case) in the constitution of the semiconductor device shown in Figures 2, 3F, 4D, 5 and 6, the device has the structure of an $I^2L$ (Integrated Injection Logic) device.

**Claims**

1. A semiconductor device comprising:
   a semiconductor substrate (1, 2) with a mesa region (3) of a first conductivity type,
   a first insulating film (6) provided over the portions other that the mesa region (3) of said substrate (1, 2),
   a first region (18) of a polycrystalline silicon layer having a second conductivity type and being provided over said insulating film (6) in contact with said mesa region (3),

a second region (4) of said second conductivity type in contact with said first region (18) and provided in the mesa region (3), and

a second insulating film (8; 24, 25) provided over said first and second regions (18; 4),

characterized in that a third region (19; 23) of metal silicide is provided on said first region (18) and separated from the mesa region (3) by a portion of said first region (18).

2. The device of claim 1, wherein said third region (19; 23) is of a compound formed from said first region (18) and a metal film and formed into one body with said first region (18).

3. The device of claim 1 or 2, wherein said second region (4-3, 4-4) serving as a base region is provided in the surface portion of said mesa region (3), and a fourth region (5) of said first conductivity type and serving as an emitter region is provided on said second region (4-3, 4-4), the portion under said second region (4-3, 4-4) serving as a collector region to form a bipolar transistor (II).

4. The device of claim 3, further comprising a collector electrode (9) connected to said collector region, a base electrode (9) formed on said first region (18), and an emitter electrode (9) formed on said fourth region (5).

5. The device of claim 4, wherein said first insulating film (6) has an opening (27) at a position other than said mesa region (3), and said collector electrode (9) is formed in said opening (27).

6. The device of claim 4 or 5, further comprising a high impurity concentration region (2) of said first conductivity type formed in said substrate (1), said collector electrode (9) being formed on said high impurity concentration region (2).

7. The device of any of claims 1 to 6, wherein said first polycrystalline semiconductor layer (18) serves as an extrinsic base region.

8. The device of any of claims 1 to 7, wherein said second region (4) includes a pair of emitter and collector regions (4-1, 4-2) spaced from each other, and said mesa region (3) between said emitter and collector regions serves as a base region, to form a lateral bipolar transistor (I).

9. The device of claim 8, wherein said second region (4) serves as a base region, a collector region (5) of said first conductivity type is formed in said base region (4), and an emitter region of said first conductivity type is formed in said body under said mesa region (3) to form an inverse bipolar transistor (II).

10. The device of claim 9, wherein said first polycrystalline semiconductor layer (18) keeps said base region (4) of the inverse bipolar transistor (II) in contact with said collector region (4-2) of the lateral bipolar transistor (I), and said emitter region of the inverse bipolar transistor (II) extends under said mesa region (3), to form an integrated injection logic.

11. A method of manufacturing a semiconductor device comprising:

forming a semiconductor substrate (1, 2) of a single crystal having a mesa region (3) of a first conductivity type,

forming an insulation film (6) on a surface of said substrate (1, 2) other than said mesa region (3),

exposing a surface of said mesa region (3),

depositing a polycrystalline semiconductor layer (18) of a second conductivity type opposite to said first conductivity type on said mesa region (3) and on said insulation film (6),

depositing at least one layer (19) selected from a metal layer and a metal silicide layer on said polycrystalline semiconductor layer (18),

annealing said layer (18, 19) deposited on said insulation film (6), and

forming a region (4) of said second conductivity type in said mesa region (3) in contact with said polycrystalline semiconductor layer (18).

**Patentansprüche**

1. Halbleitereinrichtung, umfassend

ein Halbleitersubstrat (1, 2) mit einem Mesa-Bereich (3) eines ersten Leitfähigkeitstyps,

einen ersten Isolierfilm (6), der über von dem Mesa-Bereich (3) des Substrats (1, 2) verschiedenen Teilen vorgesehen ist,

einen über dem Isolierfilm (6) in Kontakt mit dem Mesa-Bereich (3) vorgesehenen ersten Bereich (18) einer polykristallinen Siliziumschicht eines zweiten Leitfähigkeitstypes,

einen mit dem ersten Bereich (18) in Kontakt stehenden und in dem Mesa-Bereich (3) vorgesehenen zweiten Bereich (4) des zweiten Leitfähigkeitstyps, und

einen über dem ersten und dem zweiten Bereich (18; 4) vorgesehenen zweiten Isolierfilm (8; 24, 25),

dadurch gekennzeichnet, daß auf dem ersten Bereich (18) ein dritter Bereich (19; 23) aus Metallsilicid vorgesehen ist, der von dem Mesa-Bereich (3) durch einen Teil des ersten Bereichs (18) getrennt ist.

2. Einrichtung nach Anspruch 1, wobei der dritte Bereich (19; 23) aus einer aus dem ersten Bereich (18) und einem Metallfilm gebildeten Verbindung besteht und mit dem ersten Bereich (18) als einheitlicher Körper ausgebildet ist.

3. Einrichtung nach Anspruch 1 oder 2, wobei zur Bildung eines Bipolartransistors (II) der als Basis-Bereich dienende zweite Bereich (4-3, 4-4) in einem Oberflächenteil des Mesa-Bereichs (3) vorgesehen ist und ein als Emitter-Bereich dienender vierter Bereich (5) des ersten Leitfähigkeitstyps auf dem zweiten Bereich (4-3, 4-4) vorgesehen ist, und wobei der Teil unter dem zweiten Bereich (4-3, 4-4) als Kollektor-Bereich dient.

4. Einrichtung nach Anspruch 3, ferner umfassend eine mit dem Kollektor-Bereich verbundene Kollektor-Elektrode (9), eine auf dem ersten Bereich (18) ausgebildete Basis-Elektrode (9) und eine auf dem vierten Bereich (5) ausgebildete Emitterelektrode.

5. Einrichtung nach Anspruch 4, wobei der erste Isolierfilm (6) an einer von dem Mesa-Bereich (3) verschiedenen Stelle eine Öffnung (27) aufweist, in der die Kollektor-Elektrode (9) ausgebildet ist.

6. Einrichtung nach Anspruch 4 oder 5, ferner umfassend einen in dem Substrat (1) ausgebildeten Bereich (2) des ersten Leitfähigkeitstyps mit hoher Störstoffkonzentration, auf dem die Kollektor-Elektrode (9) ausgebildet ist.

7. Einrichtung nach einem der Ansprüche 1 bis 6, wobei die erste polykristalline Halbleiterschicht (18) als Basis-Unterbereich dient.

8. Einrichtung nach einem der Ansprüche 1 bis 7, wobei zur Bildung eines lateralen Bipolartransistors (I) der zweite Bereich (4) ein Paar von in Abstand voneinander angeordneten Emitter- und Kollektor-Bereichen (4-1, 4-2) enthält und der Mesa-Bereich (3) zwischen dem Emitter- und dem Kollektor-Bereich als Basis-Bereich dient.

9. Einrichtung nach Anspruch 8, wobei zur Bildung eines inversen Bipolartransistors (II) der zweite Bereich (4) als Basis-Bereich dient, in diesem ein Kollektor-Bereich (5) des ersten Leitfähigkeitstyps ausgebildet ist, und in dem Körper unter dem Mesa-Bereich (3) ein Emitter-Bereich des ersten Leitfähigkeitstyps ausgebildet ist.

10. Einrichtung nach Anspruch 9, wobei die erste polykristalline Halbleiterschicht (18) den Basis-Bereich (4) des inversen Bipolartransistors (II) in Kontakt mit dem Kollektor-Bereich (4-2) des lateralen Bipolartransistors (I) hält, und wobei sich zur Bildung einer integrierten Injektions-Logikanordnung der Emitter-Bereich des inversen Bipolartransistors (II) unter den Mesa-Bereich (3) erstreckt.

11. Verfahren zur Herstellung einer Halbleitereinrichtung, wobei

aus einem Einkristall ein Halbleitersubstrat (1, 2) mit einem Mesa-Bereich (3) eines ersten Leitfähigkeitstyps gebildet wird,

auf einer von dem Mesa-Bereich (3) verschiedenen Oberfläche des Substrats (1, 2) ein Isolierfilm (6) ausgebildet wird,

eine Fläche des Mesa-Bereichs (3) freigelegt wird,

auf den Mesa-Bereich (3) und den Isolierfilm (6) eine polykristalline Halbleiterschicht (18) eines zu dem ersten Leitfähigkeitstyps entgegengesetzten zweiten Leitfähigkeitstyps aufgetragen wird,

auf die polykristalline Halbleiterschicht (18) mindestens eine Schicht (19), nämlich mindestens eine Metallschicht oder eine Metallsilicid-Schicht, aufgetragen wird,

die auf der Isolierschicht (6) aufgetragenen Schichten (18, 19) wärmebehandelt werden, und

in dem Mesa-Bereich (3) in Kontakt mit der ersten polykristallinen Halbleiterschicht (18) ein Bereich (4) des zweiten Leitfähigkeitstyps ausgebildet wird.

**Revendications**

1. Dispositif à semiconducteurs comportant

un substrat semiconducteur (1, 2) comportant une région mésa (3) d'un premier type de conductivité,

une première pellicule isolante (6) disposée au-dessus des parties autres que la région mésa (3) dudit substrat (1, 2),

une première région (18) d'une couche de silicium polycristallin possédant un second type de conductivité et étant disposée au-dessus de ladite pellicule isolante (6) en contact avec ladite région mésa (3),

une seconde région (4) dudit second type de conductivité en contact avec ladite première région (18) et prévue dans la région mésa (3), et

une seconde pellicule isolante (8; 24, 25) prévue au-dessus desdites première et seconde région (18; 4), caractérisé en ce qu'une troisième région (19; 23) de siliciure de métal est prévue sur ladite première région (18) et séparée de la région mésa (3) par une partie de ladite première région (18).

2. Dispositif selon la revendication 1, dans lequel ladite troisième région (19; 23) est une combinaison formée de ladite première région (18) et d'une pellicule de métal et formée en un corps avec ladite première région (18).

3. Dispositif selon la revendication 1 ou 2, dans lequel ladite seconde région (4-3, 4-4) servant de région de base est prévue dans la partie superficielle de ladite région mésa (3), et une quatrième région (5) dudit premier type de conductivité et servant de région d'émetteur est prévue sur ladite seconde région (4-3, 4-4), la partie au-dessous de ladite seconde région (4-3, 4-4), servant de collecteur pour former un transistor bipolaire (II).

4. Dispositif selon la revendication 3, comportant en outre une électrode de collecteur (9) reliée à ladite région de collecteur, une électrode de base (9) formée sur ladite première région (18), et une électrode d'émetteur (9) formée sur ladite quatrième région (5).

5. Dispositif selon la revendication 4, dans lequel ladite première pellicule isolante (6) possède une ouverture (27) en un endroit autre que ladite région mésa (3), et ladite électrode de collecteur (9) est formée dans ladite ouverture (27).

6. Dispositif selon la revendication 4 ou 5, comportant en outre une région à concentration élevée en impuretés (2) dudit premier type de conductivité formée dans ledit substrat (1), ladite électrode de collecteur (9) étant formée sur ladite région à concentration en impuretés élevée (2).

7. Dispositif selon l'une quelconque des revendications 1 à 6, dans lequel ladite première couche semiconductrice polycristalline (18) sert de région de base extrinsèque.

8. Dispositif selon l'une quelconque des revendications 1 à 7, dans lequel ladite seconde région (4) comprend une paire de régions d'émetteur et de collecteur (4-1, 4-2) espacées l'une de l'autre, et ladite région mésa (3) entre lesdites régions d'émetteur et de collecteur sert de région de base, pour former un transistor bipolaire latéral (I).

9. Dispositif selon la revendication 8, dans lequel ladite seconde région (4) sert de région de base, une région de collecteur (5) dudit premier type de conductivité est formée dans ladite région de base (4), et une région d'émetteur dudit premier type de conductivité est formée dans ledit corps au-dessous de ladite région mésa (3), pour former un transistor bipolaire inverse (II).

10. Dispositif selon la revendication 9, dans lequel ladite première couche semiconductrice polycristalline (18) maintient ladite région de base (4) du transistor bipolaire inverse (II) en contact avec ladite région de collecteur (4-2) du transistor bipolaire latéral (I), et ladite région d'émetteur du transistor bipolaire inverse (II) s'étend au-dessous de ladite région mésa (3), pour former une logique d'injection intégrée.

11. Procédé de fabrication d'un dispositif à semiconducteurs comportant les étapes consistant à:

former un substrat semiconducteur (1, 2) monocristallin possédant une région mésa (3) d'un premier type de conductivité;

former une pellicule isolante (6) sur une surface dudit substrat (1, 2) autre que ladite région mésa (3),

mettre à nu une surface de ladite région mésa (3),

déposer une couche semiconductrice polycristalline (18) d'un second type de conductivité opposé audit premier type de conductivité sur ladite région mésa (3) et sur ladite pellicule isolante (6),

déposer au moins une couche (19) choisie parmi une couche de métal et une couche de siliciure de métal sur ladite couche semiconductrice polycristalline (18),

recuire lesdites couches (18, 19) déposées sur ladite pellicule isolante (6), et

former une région (4) dudit second type de conductivité dans ladite région mésa (3) en contact avec ladite couche semiconductrice polycristalline (18).

# FIG. 1

# FIG. 2

## FIG. 3A

## FIG. 3B

## FIG. 3C

## FIG. 3D

## FIG. 3E

## FIG. 3F

FIG. 4A

FIG. 4B

FIG. 4C

FIG. 4D